# EUROPÄISCHE PATENTSCHRIFT

(11) **EP 3 535 965 B1**
(45) Veröffentlichungstag und Bekanntmachung des Hinweises auf die Patenterteilung: **10.11.2021**
(21) Anmeldenummer: 17768073.3
(22) Anmeldetag: 12.09.2017
(51) Int. Cl.: H04N 5/335, H04N 17/00, G06F 11/07, H01L 21/66, G01R 31/3181, B60R 11/04

(54) **VERFAHREN UND VORRICHTUNG ZUM ÜBERWACHEN EINES BILDSENSORS**
METHOD AND DEVICE FOR MONITORING AN IMAGE SENSOR
PROCÉDÉ ET DISPOSITIF DE SURVEILLANCE D'UN CAPTEUR D'IMAGE

(30) Priorität: 02.11.2016 DE 102016221441
(43) Veröffentlichungstag der Anmeldung: 11.09.2019
(73) Patentinhaber: Robert Bosch GmbH, 70442 Stuttgart (DE)
(72) Erfinder: MUELLER, Bernd, 71229 Leonberg (DE); BEUTNAGEL-BUCHNER, Uwe, 70327 Stuttgart (DE)
(86) Internationale Anmeldenummer: PCT/EP2017/072834
(87) Internationale Veröffentlichungsnummer: WO 2018/082836

(56) Entgegenhaltungen:
- WO-A1-91/04498
- WO-A1-2004/045912
- WO-A1-2006/087628
- GB-A- 2 334 848
- US-A1- 2008 158 363
- US-A1- 2016 301 923
- US-B1- 7 085 408

## Beschreibung

### Stand der Technik

Die Erfindung geht aus von einer Vorrichtung oder einem Verfahren nach Gattung der unabhängigen Ansprüche. Gegenstand der vorliegenden Erfindung ist auch ein Computerprogramm.

Videobasierte Systeme in Kraftfahrzeugen können für sicherheitsrelevante Funktionen verwendet werden. Dabei kann ein Bildsensor zur Digitalisierung optischer Informationen verwendet werden, während ein Mikroprozessor die weitere Verarbeitung der digitalisierten Bilder übernimmt.

Es sind verschiedene Verfahren zur internen Überwachung eines solchen Bildsensors bekannt, beispielsweise die Speicherabsicherung über Parity oder ECC oder die Verwendung dedizierter Konfigurations-CRC oder Counter. US 7 085 408 B1 offenbart ein Verfahren zum Lokalisieren eines Defekts in einem Bildsensor. Dabei werden Testdaten von einer Testmaschine in Bildverarbeitungskomponenten eingespeist, von diesen verarbeitet und anschließend ausgewertet. WO 2004/045912 A1 offenbart einen Bildgeber, der ein aufgenommenes Bild auswertet, um seine Funktionsfähigkeit zu überwachen. WO 91/04498 A1 offenbart eine bildsensierende integrierte Schaltung, die auch eine Testschaltung umfasst.

### Offenbarung der Erfindung

Vor diesem Hintergrund werden mit dem hier vorgestellten Ansatz ein Verfahren zum Überwachen eines Bildsensors, weiterhin eine Vorrichtung, die dieses Verfahren verwendet, sowie schließlich ein entsprechendes Computerprogramm gemäß den Hauptansprüchen vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Es wird ein Verfahren zum Überwachen eines Bildsensors vorgestellt, wobei der Bildsensor eine Kommunikationsschnittstelle zum Kommunizieren mit einer externen Überwachungseinheit aufweist, wobei das Verfahren folgende Schritte umfasst:
Einlesen eines von der Überwachungseinheit erzeugten Aufforderungssignals über die Kommunikationsschnittstelle;
Modifizieren eines von dem Bildsensor erzeugten Testmusters unter Verwendung des Aufforderungssignals, um ein modifiziertes Testmuster zu erhalten; und
Ausgeben des modifizierten Testmusters an die Kommunikationsschnittstelle, um das modifizierte Testmuster durch die Überwachungseinheit auswerten zu lassen.

Unter einem Bildsensor kann beispielsweise ein CCD- oder CMOS-Sensor verstanden werden. Unter einer externen Überwachungseinheit kann beispielsweise eine Verarbeitungseinheit in Form eines Mikrocontrollers oder Mikroprozessors verstanden werden. Unter einem Aufforderungssignal kann eine Challenge, d. h. eine Frage oder Aufgabe in Form eines entsprechenden Bitmusters, verstanden werden. Unter einem Testmuster kann je nach Ausführungsform an Testmusteranteil eines von dem Bildsensor erzeugten Bildes, etwa zumindest eine Zeile oder Spalte des Bildes, oder auch ein eigenes Testbild verstanden werden. Um das Testmuster zu erzeugen, kann der Bildsensor beispielsweise einem Bild einige Bildzeilen oder -spalten als das Testmuster hinzufügen. Bei dem modifizierten Testmuster kann es sich um eine Response, d. h. um eine Antwort auf die Challenge in Form eines entsprechenden Antwortbitmusters handeln. Beispielsweise kann der Bildsensor basierend auf dem Aufforderungssignal interne Maßnahmen wie etwa Berechnungen durchführen, die in die Generierung der Response in Form einer Modifizierung des Testmusters münden. Diese Response kann an die Überwachungseinheit, die die einzig richtige Response kennt oder auch erstellen kann, zurückgeschickt werden und durch diese überprüft werden.

Der hier vorgestellte Ansatz beruht auf der Erkenntnis, dass eine externe Überwachung eines Bildsensors auf der Basis eines Challenge-Response-Verfahrens realisiert werden kann, wobei beispielsweise ein Mikrocontroller oder -prozessor Challenges an den Bildsensor übertragen kann. Durch ein derartiges Verfahren kann eine typische Response-Generierung dadurch erweitert werden, dass ein Testmusteranteil von Bildern in Abhängigkeit von der jeweils gesendeten Challenge dynamisch verändert wird. Somit kann die Überwachung des Bildsensors verbessert werden und ein höheres Sicherheitslevel wie etwa ein höheres ASIL (ASIL= Automotive Safety Integrity Level) erreicht werden.

Der Vorteil des hier vorgestellten Ansatzes besteht in der externen Überwachung des Bildsensors, indem diese eine Sicherheitsargumentation über die Verwendung mehrerer Komponenten ermöglicht. Dadurch wird eine Gesamtüberwachung der Wirkkette selbst für höhere Anwendungsschichten in der Bildverarbeitung ermöglicht.

Gemäß einer Ausführungsform kann im Schritt des Ausgebens das modifizierte Testmuster als Teil eines von dem Bildsensor erzeugten Bildes ausgegeben werden. Dadurch kann sichergestellt werden, dass das modifizierte Testmuster zeitgleich mit dem von dem Bildsensor erzeugten Bild ausgegeben wird.

Gemäß einer weiteren Ausführungsform kann im Schritt des Modifizierens das modifizierte Testmuster stückweise erzeugt werden. Entsprechend können im Schritt des Ausgebens Stücke des modifizierten Testmusters ausgegeben werden. Beispielsweise kann das modifizierte Testmuster zeilen- oder spaltenweise oder sowohl zeilen- als auch spaltenweise erzeugt werden. Die Stücke des modifizierten Testmusters können im Schritt des Ausgebens beispielsweise synchron mit einem Bildsendetakt des Bildsensors ausgegeben werden. Durch diese Ausführungsform kann auf Zwischenspeicher zum Zwischenspeichern des modifizierten Testmusters verzichtet werden.

Ferner ist es vorteilhaft, wenn im Schritt des Modifizierens das modifizierte Testmuster ausgehend von einem Startwert unter Verwendung einer Verarbeitungsvorschrift sequenziell erzeugt wird. Unter einer Verarbeitungsvorschrift kann beispielsweise eine Logik wie etwa eine State-Machine, auch Zustandsmaschine oder -automat genannt, verstanden werden. Unter einem Startwert kann etwa ein Seed-Value der Logik verstanden werden. Dadurch kann das modifizierte Testmuster besonders effizient erzeugt werden.

Das Verfahren kann zudem einen Schritt des Erzeugens des Aufforderungssignals abhängig von einem Bildsendetakt des Bildsensors umfassen. Dadurch kann der Bildsensor mit hoher Effizienz überwacht werden.

Hierbei kann im Schritt des Erzeugens das Aufforderungssignal synchron mit dem Bildsendetakt erzeugt werden. Beispielsweise kann das Aufforderungssignal für jedes einzelne von dem Bildsensor erzeugte Bild erzeugt werden. Alternativ kann das Aufforderungssignal beispielsweise auch für jedes n-te von dem Bildsensor erzeugte Bild erzeugt werden. Durch diese Ausführungsform kann die Effizienz der Überwachung des Bildsensors weiter erhöht werden.

Von Vorteil ist auch, wenn in einem Schritt des Auswertens das modifizierte Testmuster ausgewertet wird, beispielsweise unter Verwendung des Aufforderungssignals. Dabei kann in einem Schritt des Deaktivierens der Bildsensor deaktiviert werden, wenn das modifizierte Testmuster beim Auswerten wiederholt als fehlerhaft erkannt wird. Dadurch kann vermieden werden, dass eine einmalige falsche Testmustergenerierung zu einer sofortigen Abschaltung des Bildsensors führt.

Gemäß einer weiteren Ausführungsform kann im Schritt des Ausgebens unter Verwendung des Aufforderungssignals zumindest ein weiteres Antwortsignal ausgegeben werden, um ferner das weitere Antwortsignal durch die Überwachungseinheit auswerten zu lassen. Bei dem weiteren Antwortsignal kann es sich um eine zusätzliche Response handeln. Dadurch kann die Zuverlässigkeit des Verfahrens erhöht werden.

Es ist vorteilhaft, wenn im Schritt des Ausgebens das weitere Antwortsignal unter Verwendung zumindest eines Sicherheitsmechanismus des Bildsensors ausgegeben wird. Unter einem Sicherheitsmechanismus kann ein Mechanismus zur Selbstprüfung des Bildsensors verstanden werden. Je nach Ausführungsform kann der Bildsensor eine Mehrzahl unterschiedlicher Sicherheitsmechanismen aufweisen. Dadurch kann der Sicherheitsmechanismus in die Generierung der Response in Form des modifizierten Testmusters eingebunden werden. Somit kann eine besonders hohe Überwachungsgüte erreicht werden.

Das Verfahren kann zudem einen Schritt des Überprüfens einer Funktionsfähigkeit der Überwachungseinheit unter Verwendung des modifizierten Testmusters umfassen. Dadurch kann das modifizierte Testmuster zusätzlich zur Überwachung der Überwachungseinheit verwendet werden.

Dieses Verfahren kann beispielsweise in Software oder Hardware oder in einer Mischform aus Software und Hardware, beispielsweise in einem Steuergerät, implementiert sein.

Der hier vorgestellte Ansatz schafft ferner eine Vorrichtung, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Hierzu kann die Vorrichtung zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Daten- oder Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einer Vorrichtung kann vorliegend ein elektrisches Gerät verstanden werden, das Sensorsignale verarbeitet und in Abhängigkeit davon Steuer-und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

In einer vorteilhaften Ausgestaltung erfolgt durch die Vorrichtung eine Steuerung des Fahrzeugs. Hierzu kann die Vorrichtung beispielsweise auf Sensorsignale wie Beschleunigungs-, Druck-, Lenkwinkel- oder Umfeldsensorsignale zugreifen. Die Ansteuerung erfolgt über Aktoren wie Brems- oder Lenkaktoren oder ein Motorsteuergerät des Fahrzeugs.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Ausführungsbeispiele der Erfindung sind in den Zeichnungen dargestellt und in der nachfolgenden Beschreibung näher erläutert. Es zeigt:
Fig. 1 eine schematische Darstellung einer Vorrichtung gemäß einem Ausführungsbeispiel;
Fig. 2 eine schematische Darstellung eines von einem Bildsensor gemäß einem Ausführungsbeispiel erzeugten Bildes;
Fig. 3 ein Ablaufdiagramm eines Verfahrens gemäß einem Ausführungsbeispiel;
Fig. 4 eine schematische Darstellung eines Bildsensors gemäß einem Ausführungsbeispiel;
Fig. 5 eine schematische Darstellung eines Bildsensors gemäß einem Ausführungsbeispiel; und
Fig. 6 eine schematische Darstellung einer Überwachungseinheit gemäß einem Ausführungsbeispiel.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

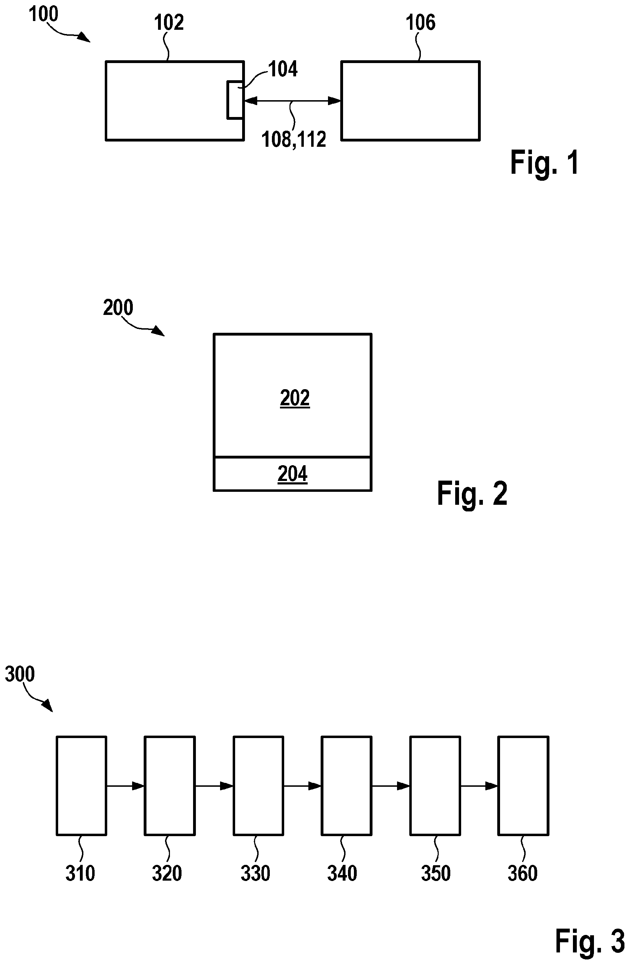

Fig. 1 zeigt eine schematische Darstellung einer Vorrichtung 100 gemäß einem Ausführungsbeispiel. Die Vorrichtung 100 umfasst einen Bildsensor 102 mit einer Kommunikationsschnittstelle 104, die mit einer Überwachungseinheit 106 zum Überwachen des Bildsensors 102 gekoppelt ist. Die Überwachungseinheit 106, beispielsweise ein Mikrocontroller oder -prozessor, ist ausgebildet, um ein Aufforderungssignal 108 zu erzeugen, auch Challenge genannt, und an die Kommunikationsschnittstelle 104 zu senden. Der Bildsensor 102 ist ausgebildet, um das Aufforderungssignal 108 einzulesen und dieses zur Modifizierung eines von dem Bildsensor 102 erzeugten Testmusters zu verarbeiten. Die Modifizierung erfolgt hierbei in Abhängigkeit von einem durch das Aufforderungssignal 108 repräsentierten Bitmuster. Das derart modifizierte Testmuster kann deshalb auch als Response bezeichnet werden, wobei der Bildsensor 102 das modifizierte Testmuster in Form eines entsprechenden

Antwortsignals 112 über die Kommunikationsschnittstelle 104 an die Überwachungseinheit 106 zurücksendet. Die Überwachungseinheit 106 verwendet das Antwortsignal 112, um durch Analysieren des modifizierten Testmusters die Funktionsfähigkeit des Bildsensors 102 zu überprüfen.

Der Bildsensor 102 ist beispielsweise zur digitalen Erfassung von Licht ausgebildet. Die Überwachungseinheit 106 kann dabei als Hardware für höhere Bildverarbeitungsschichten realisiert sein. Der Bildsensor 102 und die Überwachungseinheit 106 sind beispielsweise durch ein eventuell mehrteiliges Kommunikationssystem miteinander verbunden, wobei die Kommunikationsschnittstelle 104 Teil des Kommunikationssystems sein kann. Das Kommunikationssystem umfasst je nach Ausführungsbeispiel einen I2C- oder MIPI-Bus oder weitere Kommunikationsverbindungen. Ein typisches funktionales Szenario ist beispielsweise, dass die Überwachungseinheit 106 beim Starten des Systems Konfigurationsdaten an den Bildsensor 102 schickt, um diesen zu konfigurieren. Im Betrieb schickt der Bildsensor 102 dann Bilddaten in geeigneter Form an die Überwachungseinheit 106.

Gemäß einem Ausführungsbeispiel sind die Bilddaten derart, dass sich ein Gesamtbild aus einem Bildinhalt und einem Testmuster zusammensetzt, wie dies in Fig. 2 gezeigt ist. Das Testmuster benutzt dabei beispielsweise einige wenige Zeilen oder Spalten des Gesamtbildes.

Der Bildsensor 102 erhält über das Kommunikationssystem eine Challenge in Form des Aufforderungssignals 108. Im Bildsensor 102 wird die Challenge ausgewertet, d. h. zunächst als Challenge erkannt. Dabei wird in der entsprechenden Komponente des Bildsensors 102 derjenige Teil der Challenge, der sich auf die Modifikation des Testmusters bezieht, identifiziert und an eine weitere Komponente zur Erzeugung des modifizierten Testmusters weitergeleitet, die das durch die Challenge modifizierte Testmuster erzeugt. Dazu wird in der zuständigen Komponente beispielsweise ein Default-Verfahren durchgeführt, mit dem in jedem Fall ein Testmuster erzeugt wird, selbst wenn keine Challenge vorliegt. Das modifizierte Testmuster wird dann an eine Komponente zum Versenden des modifizierten Testmusters weitergegeben. Dabei wird das modifizierte Testmuster entweder separat, beispielsweise als eigenständiges Bild, oder eingebettet in eine Struktur, wie sie etwa in Fig. 2 gezeigt ist, verschickt. In dieser Struktur ist das modifizierte Testmuster Teil eines Bildes.

Dabei ist es besonders effizient, wenn das Bild und damit auch der das modifizierte Testmuster repräsentierende Bildanteil in Stücken gesendet wird, beispielsweise in Zeilen. Analog dazu ist es günstig, wenn die Erzeugung des modifizierten Testmusters ebenfalls in einer entsprechenden Stückgröße erfolgt, beispielsweise zeilenweise, wodurch umfangreiche Zwischenspeicher entfallen können. Dabei sollte die Erzeugung des modifizierten Testmusters mit der Übertragung des Bildes so synchronisiert werden, dass die jeweiligen Stücke im Sendetakt des Bildes geliefert werden.

Fig. 2 zeigt eine schematische Darstellung eines von einem Bildsensor gemäß einem Ausführungsbeispiel erzeugten Bildes 200. Das Bild 200 wurde beispielsweise von einem Bildsensor, wie er vorangehend anhand von Fig. 1 beschrieben ist, erzeugt. Gemäß diesem Ausführungsbeispiel umfasst das Bild einen ersten Teil 202, der einen eigentlichen Bildinhalt repräsentiert, sowie einen zweiten Teil 204, der ein Testmuster in Form einer oder mehrerer Spalten oder Zeilen des Bildes 200 repräsentiert. Der zweite Teil 204 in Gestalt des Testmusters wird beispielsweise von dem Bildsensor 202 unter Verwendung des Aufforderungssignals modifiziert, um das modifizierte Testmuster zu erhalten. Je nach Ausführungsbeispiel wird das modifizierte Testmuster in Form des Antwortsignals entweder separat oder wiederum als Teil eines zusammengesetzten Bildes, ähnlich dem in Fig. 2 gezeigten Bild, an die Überwachungseinheit übertragen.

Fig. 3 zeigt ein Ablaufdiagramm eines Verfahrens 300 gemäß einem Ausführungsbeispiel. Das Verfahren 300 zum Überwachen eines Bildsensors kann beispielsweise unter Verwendung einer Vorrichtung, wie sie vorangehend anhand der Figuren 1 und 2 beschrieben ist, durchgeführt werden. In Fig. 3 ist beispielhaft ein Grundablauf des Verfahrens 300 dargestellt. Dabei sendet die Überwachungseinheit in einem Schritt 310 eine Challenge in Form des Aufforderungssignals an die Kommunikationsschnittstelle des Bildsensors, der das Aufforderungssignal über die Kommunikationsschnittstelle einliest. Die durch das Aufforderungssignal repräsentierte Challenge ist dem Bildsensor nicht bekannt. Im Bildsensor ist aber abgelegt, wie auf irgendeine beliebige Challenge zu reagieren ist. In einem weiteren Schritt 320 initiiert der Bildsensor somit die Reaktion auf die Challenge. In einem Schritt 330 modifiziert der Bildsensor das Testmuster, das beispielsweise als Reaktion auf die Challenge in einem Bild mitgeschickt wird, anhand der Challenge. Die Modifikation des Testmusters erfolgt dabei in einer nahezu beliebigen Form, etwa durch eine einfache zyklische Verschiebung des Testmusters um einen aus der Challenge berechneten Wert, durch Ersetzen oder Austauschen einiger Reihen oder Zeilen des Testmusters oder auch durch Austauschen des Testmusters gegen ein völlig anderes Testmuster. Effizient ist es, wenn zur Erstellung des neuen Testmusters keine umfangreiche Hardware erforderlich ist. Dieses neue Testmuster sollte der Überwachungseinheit zumindest im Prinzip bekannt sein. In einem Schritt 340 wird das modifizierte Testmuster über die Kommunikationsschnittstelle an die Überwachungseinheit ausgegeben, wobei die Überwachungseinheit in einem Schritt 350 durch Auswerten des modifizierten Testmusters prüft, ob das modifizierte Testmuster seinen Erwartungen entspricht. Abschließend wird in einem Schritt 360 abhängig vom Ergebnis des Schritts 350 entschieden, ob der Weiterbetrieb des Bildsensors erlaubt ist oder ein Fehler vorliegt. Beispielsweise wird der Bildsensor im Schritt 360 deaktiviert, wenn das modifizierte Testmuster im Schritt 350 wiederholt als fehlerhaft erkannt wurde.

Das Verfahren 300 kann als ein Challenge-Response-Verfahren oder Frage-Antwort-Verfahren zur Überwachung elektronischer Komponenten, insbesondere beispielsweise auch zur gegenseitigen Überwachung, bezeichnet werden. Das Verfahren 300 ist dadurch gekennzeichnet, dass die Überwachungseinheit dem Bildsensor eine Challenge oder Frage schickt, in der Regel ein geeignetes Bitmuster, und der Bildsensor basierend auf dieser Frage interne Maßnahmen wie etwa Berechnungen durchführt, die unter anderem zur Generierung einer Response oder Antwort führen. Diese Antwort wird an die Überwachungseinheit zurückgeschickt, die die Korrektheit der Antwort prüfen kann, da sie die einzig richtige Antwort kennt oder auch erstellen kann.

Um den Schritt 330 effizient umzusetzen, ist es beispielsweise vorteilhaft, wenn das Bitmuster des Testmusters sequenziell, etwa Zeile für Zeile oder Wort für Wort, als Output einer Logik erzeugt wird und nicht aus einem Speicher ausgelesen wird. Diese Logik ist beispielsweise eine State-Machine, die alle x Taktzyklen einen neuen Wert, etwa eine neue Zeile, generiert. Je nach Ausführungsbeispiel benötigt die Logik nur einen Seed-Value, der beispielsweise aus der Challenge direkt entnommen wird, und erzeugt daraufhin eine immer weiter gehende Reihe von Werten bis hin zu Zeilen. Beispielsweise ist dann der Vorgängerwert oder die Vorgängerzeile der Startwert des nächsten Werts oder der nächsten Zeile. Damit sind zur Generierung eines kompletten Testmusters nur die Logik, der Seed-Value und die Zahl der Zeilen erforderlich.

Besonders vorteilhaft ist es, wenn die Challenge mit dem Senden von Bildern synchronisiert ist. Beispielsweise wird die Challenge genau so gesendet, dass das nächste oder übernächste (oder überübernächste usw.) Set an Bilddaten eine entsprechende Veränderung der Testmusterdaten beinhaltet. Dies erfolgt beispielsweise dadurch, dass die Challenge mit einem festen zeitlichen Abstand zum letzten Bild oder vor dem nächsten Bild gesendet wird. Auch ein variabler zeitlicher Abstand mit einer Begrenzung der Variabilität auf ein definiertes Zeitintervall kann eine solche Synchronisation darstellen. Eine solche zeitliche Kopplung oder Synchronisation ermöglicht es auch in begrenztem Umfang, den Bildsensor zur Überwachung der Überwachungseinheit einzusetzen: Wenn keine Challenge im erwarteten Zeitfenster kommt oder eine Challenge nicht legal ist, d. h. nicht einfach prüfbaren Kriterien genügt, dann wird durch den Bildsensor beispielsweise eine Fehlerreaktion eingeleitet.

Alternativ wird zu jedem Bild oder zu jedem n-ten Bild eine entsprechende Challenge geschickt. Dies ist insbesondere dann nützlich, wenn es innerhalb des Bildsensors relativ viel Zeit kostet, das entsprechend der Challenge modifizierte Testmuster zu erzeugen.

Gemäß einem weiteren Ausführungsbeispiel wird das Verfahren 300 um die Generierung einer zusätzlichen Response erweitert, die über die Änderung des Testmusters hinaus mit eingefügt wird. Dazu sendet der Bildsensor zusätzlich zum modifizierten Testmuster zumindest eine explizite andere Nachricht an die Überwachungseinheit. Günstig ist es, wenn beispielsweise eine Nachricht pro Challenge geschickt wird, etwa innerhalb eines fixierten Zeitintervalls nach der Challenge. Dies ermöglicht eine einfache zeitliche Überwachung in der

Überwachungseinheit, d. h. eine einfache Überprüfung, ob die Response zur richtigen Zeit geliefert wird.

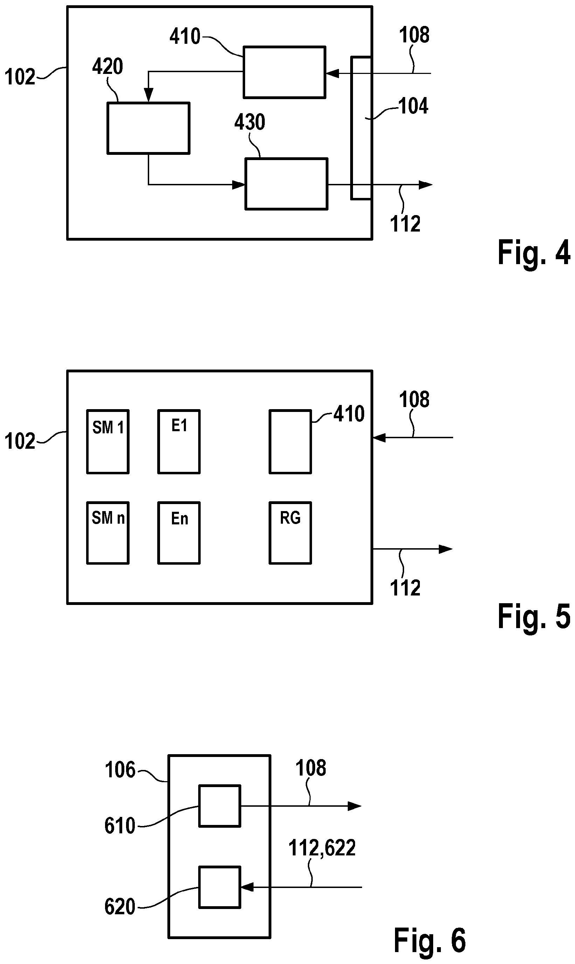

Vorteilhaft ist es zudem, wenn ein Inhalt der Response so mit der Challenge verknüpft wird, dass bildsensorinterne Sicherheits- und Überwachungsmechanismen in die Generierung der Response eingebunden werden und somit die Überwachungseinheit aus der Response auch Evidenz darüber erhält, ob die bildsensorinternen Sicherheits- und Überwachungsmechanismen aktiv sind und keinen Fehler gefunden haben. Dies erfolgt beispielsweise in einer Form, wie sie nachfolgend anhand von Fig. 5 näher beschrieben ist.

In das Challenge-basierte Verfahren 300 ist optional ein Entprellungsmechanismus eingebaut, sodass beispielsweise eine falsche Testmustergenerierung oder Response nicht sofort zu einer harten Abschaltung des Bildsensors führt. Stattdessen wird beispielsweise erst nach zwei oder drei fehlerhaften Testmustern oder Responses eine Abschaltung initiiert. Dies hat den Vorteil, dass ein Test auch im Betrieb vorgenommen werden kann, etwa indem ab und zu absichtlich ein falsches Ergebnis gesendet wird.

Um das Verfahren 300 umzusetzen, wird beispielsweise ein Bildsensor mit den in Fig. 4 gezeigten Komponenten verwendet.

Fig. 4 zeigt eine schematische Darstellung eines Bildsensors 102 gemäß einem Ausführungsbeispiel, etwa eines vorangehend anhand der Figuren 1 bis 3 beschriebenen Bildsensors. Der Bildsensor 102 umfasst die Kommunikationsschnittstelle 104 zum Einlesen des Aufforderungssignals 108, das durch eine Auswerteeinheit 410 ausgewertet wird, um die Reaktion auf die durch das Aufforderungssignal 108 repräsentierte Challenge zu initiieren. Eine Modifikationseinheit 420 ist ausgebildet, um ansprechend auf die Initiierung der Reaktion das modifizierte Testmuster in Form des Antwortsignals 112 zu erzeugen. Eine Ausgabeeinheit 430 ist ausgebildet, um das Antwortsignal 112 wiederum über die Kommunikationsschnittstelle 104 zu versenden.

Fig. 5 zeigt eine schematische Darstellung eines Bildsensors 102 gemäß einem Ausführungsbeispiel. Im Unterschied zu Fig. 4 ist der Bildsensor 102 gemäß diesem Ausführungsbeispiel mit einer Mehrzahl von Sicherheitsmechanismen SM1 bis SMn sowie einer Responsegenerierungseinheit RG realisiert. Dabei ist die Responsegenerierungseinheit RG ausgebildet, um das Antwortsignal 112 unter Verwendung von von den Sicherheitsmechanismen bereitgestellten Ergebnissen zu erzeugen.

Die Sicherheits- und Überwachungsmechanismen SM1 bis SMn sind beispielsweise in einer solchen Form implementiert, dass sie je ein Ergebnis E1 bis En liefern. Dies wird bei einem zyklischen Test beispielsweise erreicht, indem ein jeweiliges Testergebnis, "pass" oder "fail", Teil des Ergebnisses ist, beispielsweise von verwendeten Testdaten, eines Counters oder eines Zeitstempels. Bei einer quasikontinuierlich verlaufenden Software-Plausibilisierung kann das eine im Code vorhergesehene Folge von Mustern sein, die in einen Speicher geschrieben werden, oder auch nur eine Feststellung einer Reihenfolge von Schritten, die im Ablauf vorkommen, wobei der Test als bestanden gilt, wenn die Reihenfolge als "richtig" erkannt wird. Es kann jeder Sicherheitsmechanismus eingebunden werden, der so implementierbar ist, dass er ein im Speicher darstellbares Ergebnis liefert. Entscheidend ist nun, dass das Ergebnis des Sicherheitsmechanismus von der Challenge abhängt.

Im einfachsten Fall erfolgt dies dadurch, dass ein zunächst geliefertes Ergebnis noch mit der Challenge modifiziert wird, etwa über XOR. Ein Festfrieren des zunächst gelieferten Ergebnisses kann dabei allerdings nicht erkannt werden. Abhängig vom jeweiligen Sicherheitsmechanismus werden beispielsweise bei einem Test die verwendeten Testdaten oder eine Reihenfolge der Testdaten oder Teiltests durch die Challenge beeinflusst. Bei Software werden beispielsweise interne (Counter-)Variablen, die ins Ergebnis mit einfließen, beeinflusst. Die Auswerteeinheit 410 ist ausgebildet, um denjenigen Teil der Challenge, der für die jeweiligen Sicherheitsmechanismen gültig ist, zu identifizieren und den Sicherheitsmechanismus in geeigneter Form zur Verfügung zu stellen. In der Responsegenerierungseinheit RG werden dann die verschiedenen Ergebnisse E1 bis En zusammengefasst, gegebenenfalls verdichtet und der Überwachungseinheit zur Verfügung gestellt. Dadurch ist sichergestellt, dass sich ein von einem internen Sicherheitsmechanismus detektierter Fehler in einer entsprechend "falschen" Response äußert. Die zu einer Challenge erwartete Response ist der Überwachungseinheit bekannt. Bei Verschiedenheit zwischen erwarteter und empfangener Response wird beispielsweise eine Fehlerreaktion durch die Überwachungseinheit eingeleitet.

Gemäß einem Ausführungsbeispiel wird die Challenge auch noch durch die Responsegenerierungseinheit RG selbst eingebunden, beispielsweise indem beim Zusammenbinden der verschiedenen Ergebnisse E1 bis En eine Challenge-abhängige Reihenfolge, Auswahl oder Verknüpfungsform berücksichtigt wird.

Fig. 6 zeigt eine schematische Darstellung einer Überwachungseinheit 106 gemäß einem Ausführungsbeispiel, etwa einer vorangehend anhand der Figuren 1 bis 5 beschriebenen Überwachungseinheit. Gemäß diesem Ausführungsbeispiel umfasst die Überwachungseinheit 106 eine Erzeugungseinheit 610, die ausgebildet ist, um das Aufforderungssignal 108 abhängig von einem Bildsendetakt des Bildsensors, insbesondere beispielsweise synchron mit dem Bildsendetakt, zu erzeugen und an die Kommunikationsschnittstelle des Bildsensors zu übertragen. Des Weiteren umfasst die Überwachungseinheit 106 eine Auswerteeinheit 620, die ausgebildet ist, um das modifizierte Testmuster unter Verwendung des Antwortsignals 112 auszuwerten. Beispielsweise ist die Auswerteeinheit 620 ausgebildet, um den Bildsensor zu deaktivieren, wenn sich beim Auswerten des modifizierten Testmusters wiederholt ergibt, dass das modifizierte Testmuster fehlerhaft ist, d. h. nicht mit dem der Überwachungseinheit 106 bekannten Testmuster übereinstimmt.

Optional ist die Auswerteeinheit 620 ausgebildet, um zusätzlich zum Antwortsignal 112 zumindest ein von dem Bildsensor unter Verwendung des Aufforderungssignals 108 ausgegebenes weiteres Antwortsignal 622 auszuwerten, um die Funktionsfähigkeit des Bildsensors zu überprüfen. Das weitere Antwortsignal 622 repräsentiert beispielsweise ein unter Verwendung zumindest eines Sicherheitsmechanismus des Bildsensors erzeugtes Signal. Gemäß einem weiteren Ausführungsbeispiel ist die Auswerteeinheit 620 ausgebildet, um unter Verwendung des Antwortsignals 112 eine Funktionsfähigkeit der Überwachungseinheit 106 zu überprüfen. Hierzu wird beispielsweise ein Algorithmus, der auf einem normalen Bild abläuft, auch auf den Testmustern ausgeführt. Da die Ergebnisse auf den Testmustern bekannt sind, kann dies auch zur Überprüfung der Hardware, auf der die entsprechenden Algorithmen laufen, verwendet werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (300) zum Überwachen eines Bildsensors (102), wobei der Bildsensor (102) eine Kommunikationsschnittstelle (104) zum Kommunizieren mit einer externen Überwachungseinheit (106) aufweist, wobei das Verfahren (300) folgende Schritte umfasst:
Einlesen (310) eines von der Überwachungseinheit (106) erzeugten Aufforderungssignals (108) über die Kommunikationsschnittstelle (104);
Modifizieren (330) eines von dem Bildsensor (102) erzeugten Bildes (200), das einen ersten Teil (202), der einen eigentlichen Bildinhalt repräsentiert, sowie einen zweiten Teil (204) umfasst, der ein Testmuster repräsentiert, wobei der zweite Teil (204) unter Verwendung des Aufforderungssignals (108) modifiziert wird, um ein modifiziertes Testmuster zu erhalten; und
Ausgeben (340) des modifizierten Testmusters an die Kommunikationsschnittstelle (104), um das modifizierte Testmuster durch die Überwachungseinheit (106) auswerten zu lassen.

2. Verfahren (300) gemäß Anspruch 1, bei dem im Schritt des Ausgebens (340) das modifizierte Testmuster als Teil eines von dem Bildsensor (102) erzeugten Bildes (200) ausgegeben wird.

3. Verfahren (300) gemäß einem der vorangegangenen Ansprüche, bei dem im Schritt des Modifizierens (330) das modifizierte Testmuster stückweise erzeugt wird, wobei im Schritt des Ausgebens (340) Stücke des modifizierten Testmusters ausgegeben werden.

4. Verfahren (300) gemäß einem der vorangegangenen Ansprüche, bei dem im Schritt des Modifizierens (330) das modifizierte Testmuster ausgehend von einem Startwert unter Verwendung einer Verarbeitungsvorschrift sequenziell erzeugt wird.

5. Verfahren (300) gemäß einem der vorangegangenen Ansprüche, mit einem Schritt des Erzeugens des Aufforderungssignals (108) abhängig von einem Bildsendetakt des Bildsensors (102).

6. Verfahren (300) gemäß Anspruch 5, bei dem im Schritt des Erzeugens das Aufforderungssignal (108) synchron mit dem Bildsendetakt erzeugt wird.

7. Verfahren (300) gemäß einem der vorangegangenen Ansprüche, mit einem Schritt des Auswertens (350) des modifizierten Testmusters, wobei in einem Schritt des Deaktivierens (360) der Bildsensor (102) deaktiviert wird, wenn das modifizierte Testmuster beim Auswerten (350) wiederholt als fehlerhaft erkannt wird.

8. Verfahren (300) gemäß einem der vorangegangenen Ansprüche, bei dem im Schritt des Ausgebens (340) unter Verwendung des Aufforderungssignals (108) zumindest ein weiteres Antwortsignal (622) ausgegeben wird, um ferner das weitere Antwortsignal (622) durch die Überwachungseinheit (106) auswerten zu lassen.

9. Verfahren (300) gemäß Anspruch 8, bei dem im Schritt des Ausgebens (340) das weitere Antwortsignal (622) unter Verwendung zumindest eines Sicherheitsmechanismus (SM1, SMn) des Bildsensors (102) ausgegeben wird.

10. Verfahren (300) gemäß einem der vorangegangenen Ansprüche, mit einem Schritt des Überprüfens einer Funktionsfähigkeit der Überwachungseinheit (106) unter Verwendung des modifizierten Testmusters.

11. Vorrichtung (100) mit folgenden Merkmalen:
einer Überwachungseinheit (106), die ausgebildet ist, um ein Aufforderungssignal (108) zu erzeugen; und
einem Bildsensor (102) mit einer Kommunikationsschnittstelle (104) zum Einlesen (310) des von der Überwachungseinheit (106) erzeugten Aufforderungssignals (108), mit einer Modifikationseinheit (420) zum Modifizieren eines von dem Bildsensor (102) erzeugten Bildes (200), das einen ersten Teil (202), der einen eigentlichen Bildinhalt repräsentiert,
sowie einen zweiten Teil (204) umfasst, der ein Testmuster repräsentiert, wobei der zweite Teil (204) unter Verwendung des Aufforderungssignals (108) modifiziert wird, um ein modifiziertes Testmuster zu erhalten, und mit einer Ausgabeeinheit (430) zum Ausgeben (340) des modifizierten Testmusters an die Kommunikationsschnittstelle (104), um das modifizierte Testmuster durch die Überwachungseinheit (106) auswerten zu lassen.

12. Computerprogramm, umfassend Befehle, die bei der Ausführung des Programms durch einen Computer diesen veranlassen, das Verfahren (300) gemäß einem der Ansprüche 1 bis 10 auszuführen.

13. Maschinenlesbares Speichermedium, auf dem das Computerprogramm nach Anspruch 12 gespeichert ist.

## Claims

1. Method (300) for monitoring an image sensor (102), wherein the image sensor (102) has a communication interface (104) for communicating with an external monitoring unit (106), wherein the method (300) comprises the following steps:
reading (310) a request signal (108) generated by the monitoring unit (106) via the communication interface (104) ;
modifying (330) an image (200) that is generated by the image sensor (102) and comprises a first part (202) representing an actual image content and a second part (204) representing a test pattern, wherein the second part (204) is modified using the request signal (108) in order to obtain a modified test pattern; and
outputting (340) the modified test pattern to the communication interface (104) to enable the monitoring unit (106) to evaluate the modified test pattern.

2. Method (300) according to Claim 1, in which, in the outputting step (340), the modified test pattern is output as part of an image (200) generated by the image sensor (102).

3. Method (300) according to either of the preceding claims, in which, in the modification step (330), the modified test pattern is generated piece by piece, wherein pieces of the modified test pattern are output in the outputting step (340).

4. Method (300) according to one of the preceding claims, in which, in the modification step (330), the modified test pattern is sequentially generated proceeding from a starting value using a processing specification.

5. Method (300) according to one of the preceding claims, having a step of generating the request signal (108) in dependence on an image transmission clock of the image sensor (102).

6. Method (300) according to Claim 5, in which, in the generation step, the request signal (108) is generated synchronously with the image transmission clock.

7. Method (300) according to one of the preceding claims, including a step of evaluating (350) the modified test pattern, wherein, in a deactivation step (360), the image sensor (102) is deactivated if the modified test pattern is repeatedly identified as being faulty during the evaluation (350).

8. Method (300) according to one of the preceding claims, in which, in the outputting step (340), at least one further response signal (622) is output using the request signal (108) in order to enable the monitoring unit (106) to evaluate the further response signal (622).

9. Method (300) according to Claim 8, in which, in the outputting step (340), the further response signal (622) is output using at least one security mechanism (SM1, SMn) of the image sensor (102).

10. Method (300) according to one of the preceding claims, having a step of checking a functioning of the monitoring unit (106) using the modified test pattern.

11. Apparatus (100) having the following features:
a monitoring unit (106), which is configured to generate a request signal (108); and
an image sensor (102) having a communication interface (104) for reading (310) the request signal (108) generated by the monitoring unit (106), having a modification unit (420) for modifying an image (200), which is generated by the image sensor (102) and
comprises a first part (202) representing an actual image content and a second part (204) representing a test pattern, wherein the second part (204) is modified using the request signal (108) to obtain a modified test pattern, and having an output unit (430) for outputting (340) the modified test pattern to the communication interface (104) to enable the monitoring unit (106) to evaluate the modified test pattern.

12. Computer program, comprising commands that, when the program is executed by a computer, prompt the latter to carry out the method (300) according to one of Claims 1 to 10.

13. Machine-readable storage medium, on which the computer program according to Claim 12 is stored.

## Revendications

1. Procédé (300) de surveillance d'un capteur d'image (102), le capteur d'image (102) présentant une interface de communication (104) pour communiquer avec une unité de surveillance externe (106), le procédé (300) comprenant les étapes suivantes consistant à :
lire (310) un signal de demande (108), produit par l'unité de surveillance (106), par l'intermédiaire de l'interface de communication (104) ;
modifier (330) une image (200) produite par le capteur d'image (102) qui comprend une première partie (202) représentant un contenu d'image proprement dit ainsi qu'une deuxième partie (204) représentant une mire de test, la deuxième partie (204) étant modifiée en utilisant le signal de demande (108) afin d'obtenir une mire de test modifiée ; et
émettre en sortie (340) la mire de test modifiée vers l'interface de communication (104) pour faire évaluer la mire de test par l'unité de surveillance (106).

2. Procédé (300) selon la revendication 1, dans lequel à l'étape de l'émission en sortie (340), la mire de test modifiée est émise en sortie comme une partie d'une image (200) produite par le capteur d'image (102).

3. Procédé (300) selon l'une quelconque des revendications précédentes, dans lequel à l'étape de modification (330), la mire de test modifiée est produite pièce par pièce, dans lequel à l'étape de l'émission en sortie (340), des pièces de la mire de test modifiée sont émises en sortie.

4. Procédé (300) selon l'une quelconque des revendications précédentes, dans lequel à l'étape de modification (330), la mire de test modifiée est produite de manière séquentielle en partant d'une valeur de départ en utilisant une règle de traitement.

5. Procédé (300) selon l'une quelconque des revendications précédentes, comprenant une étape consistant à produire le signal de demande (108) en fonction d'un cycle d'émission d'image du capteur d'image (102) .

6. Procédé (300) selon la revendication 5, dans lequel à l'étape de production, le signal de demande (108) est produit de manière synchrone avec le cycle d'émission d'image.

7. Procédé (300) selon l'une quelconque des revendications précédentes, comprenant une étape consistant à évaluer (350) la mire de test modifiée, dans lequel dans une étape de désactivation (360), le capteur d'image (102) est désactivé lorsque la mire de test modifiée est identifiée à plusieurs reprises comme étant erronée lors de l'évaluation (350).

8. Procédé (300) selon l'une quelconque des revendications précédentes, dans lequel à l'étape de l'émission en sortie (340), en utilisant le signal de demande (108), au moins un autre signal de réponse (622) est émis en sortie pour faire évaluer en outre l'autre signal de réponse (622) par l'unité de surveillance (106).

9. Procédé (300) selon la revendication 8, dans lequel à l'étape de l'émission en sortie (340), l'autre signal de réponse (622) est émis en sortie en utilisant au moins un mécanisme de sécurité (SM1, SMn) du capteur d'image (102).

10. Procédé (300) selon l'une quelconque des revendications précédentes, comprenant une étape consistant à vérifier une capacité de fonctionnement de l'unité de surveillance de l'unité (106) en utilisant la mire de test modifiée.

11. Dispositif (100) ayant les particularités suivantes :
une unité de surveillance (106) qui est réalisée pour produire un signal de demande (108) ; et
un capteur d'image (102) doté d'une interface de communication (104) pour lire (310) le signal de demande (108) produit par l'unité de surveillance (106), d'une unité de modification (420) pour modifier une image (200) produite par le capteur d'image (102) qui comprend une première partie (202) représentant le contenu d'image proprement dit ainsi qu'une deuxième partie (204) représentant une mire de test, la deuxième partie (204) étant modifiée en utilisant le signal de demande (108) pour obtenir une mire de test modifiée, et d'une unité d'émission en sortie (430) pour émettre en sortie la mire de test modifiée vers l'interface de communication (104) afin de faire évaluer la mire de test modifiée par l'unité de surveillance (106).

12. Programme informatique, comprenant des instructions qui ont pour effet, lorsque le programme est exécuté par un ordinateur, que celui-ci effectue le procédé (300) selon l'une quelconque des revendications 1 à 10.

13. Support de stockage lisible par machine sur lequel est enregistré le programme informatique selon la revendication 12.
